# EUROPEAN PATENT APPLICATION

(11) **EP 1 729 356 A1**
(43) Date of publication of application: **06.12.2006**
(21) Application number: 04720183.5
(22) Date of filing: 12.03.2004
(51) Int. Cl.: H01L 51/00, H01L 29/786, H01L 21/336

(54) **SWITCHING DEVICE**

(71) Applicant: FUJI ELECTRIC HOLDINGS CO., LTD., Kawasaki-shi, Kanagawa 210-0856 (JP)
(72) Inventor: KAWAKAMI, Haruo, Yokosuka-shi, Kanagawa 2400194 (JP); KATO, Hisato, Yokosuka-shi, Kanagawa 2400194 (JP); KURODA, Masami, Yokosuka-shi, Kanagawa 2400194 (JP); SEKINE, Nobuyuki, Yokosuka-shi, Kanagawa 2400194 (JP); YAMASHIRO, Keisuke, Yokosuka-shi, Kanagawa 2400194 (JP); KOTANI, Noriko, Yokosuka-shi, Kanagawa 2400194 (JP); KATO, Kyoko, Yokosuka-shi, Kanagawa 2400194 (JP)
(74) Representative: Eidelsberg, Olivier Nathan
(86) International application number: PCT/JP2004/003302
(87) International publication number: WO 2005/088746

(57) **Abstract**

A switching device contains a thin film containing an organic material disposed between at least two electrodes, and the organic material is, for example, a triphenylamine compound represented by the general formula (I):

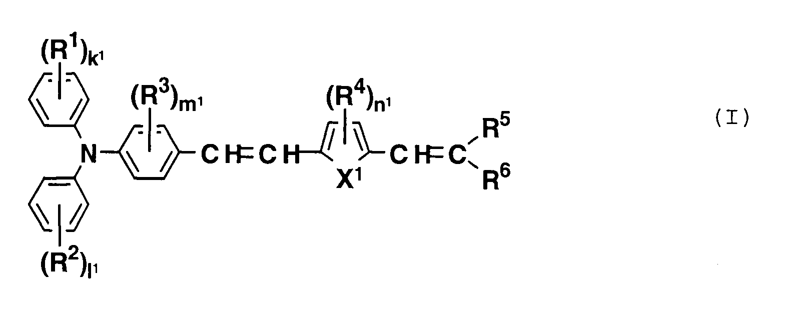

## Description

### Technical Field

The present invention relates to a switching device having an organic bistable material disposed between two electrodes, which is used as a switching device for driving an organic EL display panel, and a high density memory.

### Background Art

An organic electronic material is making significant progress in characteristics in recent years. In particular, some kinds of low dimensional conductors, such as a charge transfer complex, have such a characteristic nature as metal-insulator transition, and are investigated for application to a switching device for driving an organic EL display panel, and a high density memory.

An organic bistable material is receiving attention as a material capable of being applied to the switching device. The organic bistable material is an organic material exhibiting a so-called nonlinear response, in which upon applying a voltage to the material, the electric current flowing in the material is rapidly increased at a certain voltage or higher to exhibit a switching phenomenon.

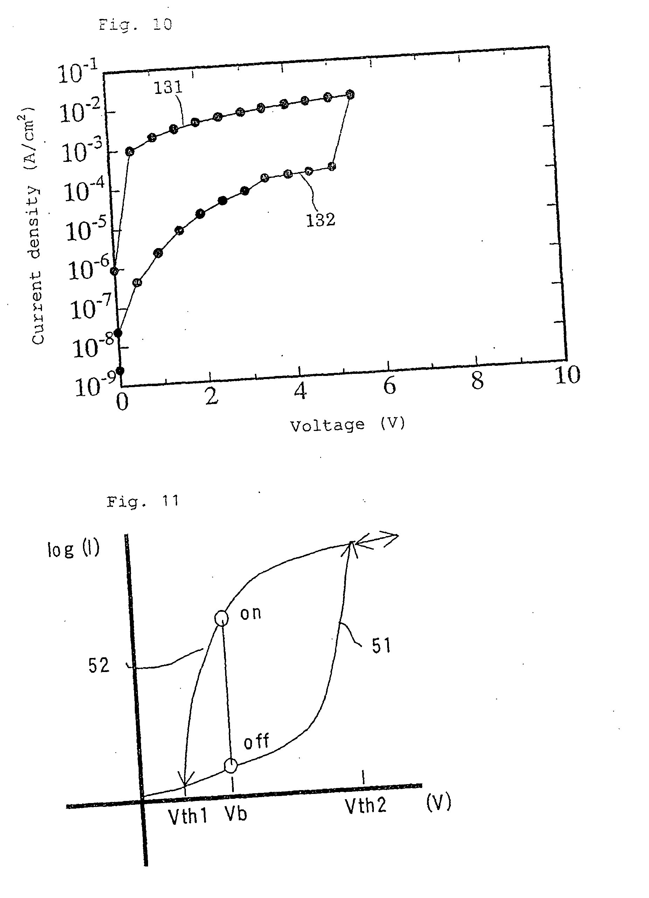

Fig. 11 shows an example of voltage-current characteristics of an organic bistable material exhibiting the switching behavior described as above.

As shown in Fig. 11, the organic bistable material has two modes of current-voltage characteristics, i.e., high resistance characteristics 51 (off state) and low resistance characteristics 52 (on state), and undergoes change in resistance value with nonlinear response characteristics, in which upon applying a bias Vb in advance, when the vol tage becomes Vth2 (high transition voltage) or more, it transits from the off state to the on state, and when the voltage becomes Vth1 (low transition voltage) or less, it transits from the on state to the off state. Accordingly, the organic bistable material can exhibit a so-called switching operation by applying a voltage of Vth2 or more and Vth1 or less. The voltages Vth1 and Vth2 may be applied as a pulsewise voltage.

As the organic bistable material exhibiting the nonlinear response, various kinds of organic complexes have been known. For example, R.S. Potember, et al. report production of a switching device having two stable resistance value to voltage by using a Cu-TCNQ (copper-tetracyanoquinodimethane) complex (R.S. Potember, et al., Appl. Phys. Lett., vol. 34, p. 405 (1979)).

Kumai, et al. , report observation of a switching behavior by a nonlinear response of a single crystal of a K-TCNQ (potassium-tetracyanoquinodimethane) complex (Kumai, et al., Kotai Butsuri (Solid Physics), vol. 35, p. 35 (2000)).

Adachi, et al. report formation of a Cu-TCNQ complex thin film by a vacuum vapor deposition method, and clarify the switching characteristics thereof to investigate possible application thereof to an organic EL matrix (Adachi, et la., Preprints of Spring Meeting of 2002 of the Japan Society of Applied Physics, Third Part Issue, p. 1236).

However, the switching devices using the aforementioned organic charge transfer complexes have the following problem. The aforementioned organic bistable material is a charge transfer complex and thus is a two-component material having a combination of a donating molecule or a metallic element having a donating nature and an accepting molecule, such as TCQN.

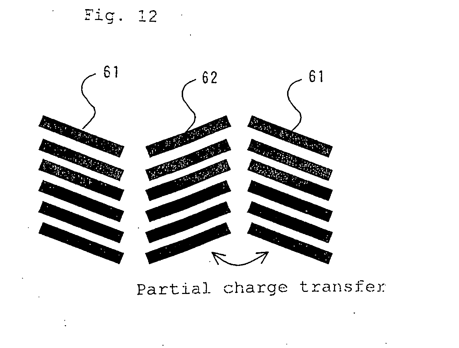

Accordingly, it is necessary upon producing a switching device to control strictly the constitutional ratio of the two components. In the two-component charge transfer complex, as shown in Fig. 12, for example, donor molecules and acceptor molecules are accumulated in column forms, respectively, to form a donor molecule column 61 and an acceptor molecule column 62, and the respective column components undergo partial charge transfer between molecules (or metallic atoms) to exhibit the bistable characteristics. Therefore, the whole bistable characteristics are heavily affected when the constitutional ratio of the two components suffers excess or deficiency.

In the Cu-TCNQ complex, for example, accordingly, a difference in constitutional ratio of Cu and TCNQ provides a difference in crystallinity and electric characteristics of the material, which brings about fluctuation in bistable characteristics. In the case where film formation is carried out by a vacuum vapor deposition method, in particular, it is difficult to form a uniform film over a large area due to the difference of vapor pressure between two components and the geometric arrangement of separate vapor deposition sources of the materials used in a vapor co-deposition method. Therefore, the conventional two-component organic bistable material has such a problem that it is difficult to mass-produce a switching device having constant quality with no fluctuation in bistable characteristics. Furthermore, a switching device using the switching device having the organic charge transfer complex has such a problem that the device has a high transition voltage Vth2 from the off state to the on state of about 10 V, as shown in Fig. 11 but is insufficient in repetition performance.

The invention has been made in view of the aforementioned problems associated with the conventional techniques, and an object thereof is to provide such a switching device that is obtained by an organic thin film process, is suppressed in fluctuation in material composition, is capable of providing uniform bistable characteristics, is suitable for mass-production, and is excellent in repetition performance.

### Disclosure of the Invention

The switching device of the invention is, in one aspect, a switching device containing a thin film containing an organic material disposed between at least two electrodes, characterized in that the organic material is a triphenylamine compound represented by the following general formula (I): 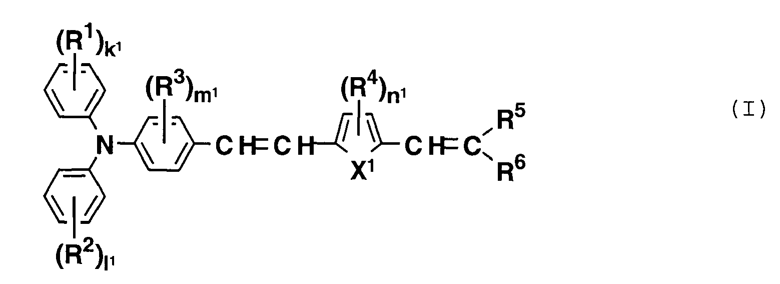 wherein R¹ to R⁴ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, and a residual group forming a ring, which may have a substituent, provided that R¹ to R⁴ may be the same as or different from each other; R⁵ and R⁶ each represents one selected from an alkyl group having from 1 to 6 carbon atoms, which may have a substituent, an aryl group, which may have a substituent, a heterocyclic group, which may have a substituent, and a residual group forming a ring, which may have a substituent, provided that R⁵ and R⁶ may be the same as or different from each other; X¹ represents an oxygen atom or a sulfur atom; k¹ and l¹ each represents an integer of from 1 to 5; m¹ represents an integer of from 1 to 4; and n¹ represents an integer of 1 or 2.

The switching device of the invention is, in another aspect, a switching device containing a thin film containing an organic material disposed between at least two electrodes, characterized in that the organic material is a triphenylamine compound represented by the following general formula (II): 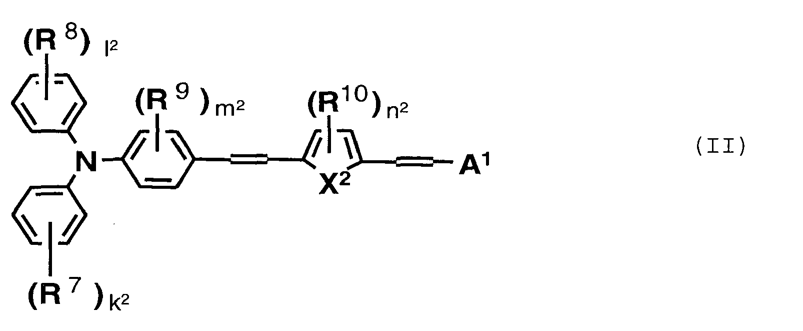 wherein R⁷ to R¹⁰ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, anda residual group forming a ring, which may have a substituent, provided that R⁷ to R¹⁰ may be the same as or different from each other; A¹ represents an aromatic condensed polycyclic group, which may have a substituent; X² represents an oxygen atom or a sulfur atom; k² and l² each represents an integer of from 1 to 5; m² represents an integer of from 1 to 4; and n² represents an integer of 1 or 2.

The switching device of the invention is, in still another aspect, a switching device containing a thin film containing an organic material disposed between at least two electrodes, characterized in that the organic material is a triphenylamine compound represented by the following general formula (III): 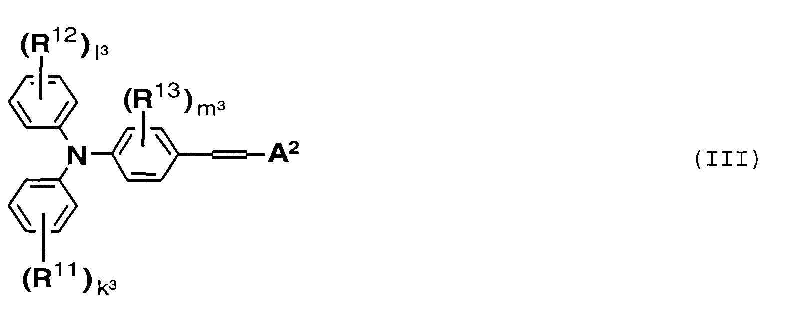 wherein R¹¹ to R¹³ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, anda residual group forming a ring, which may have a substituent, provided that R¹¹ to R¹³ may be the same as or different from each other; A² represents an aromatic condensed polycyclic group, which may have a substituent; k³ and l³ each represents an integer of from 1 to 5; and m³ represents an integer of from 1 to 4.

According to the switching devices, the triphenylamine compounds represented by the formulae (I) to (III) are materials that readily provide a large dipole moment owing to the triphenylamine group having a strong electron donating nature, whereby excellent bistability can be obtained with a large ratio of the low resistance state and the high resistance state.

The organic bistable materials are of a one-component system and are free of fluctuation in constitutional ratio upon production, which occurs in the conventional two-component organic bistable material, whereby constant bistable capability can be stably obtained.

In the case where the triphenylamine compounds represented by the formulae (I) to (III) are formed into a thin film by a vapor deposition method, they are free of complicated operations, such as vapor co-deposition, whereby a device can be produced with high production efficiency, over a large area uniformly, and at low cost.

### Brief Description of the Drawings

Fig. 1 is a schematic constitutional view showing one embodiment of the switching device of the invention.
Fig. 2 is a schematic constitutional view showing another embodiment of the switching device of the invention.
Fig. 3 is a schematic constitutional view showing still another embodiment of the switching device of the invention.
Fig. 4 is a diagram showing current-voltage characteristics of a switching device in Example 1.
Fig. 5 is a diagram showing current-voltage characteristics of a switching device in Example 2.
Fig. 6 is a diagram showing current-voltage characteristics of a switching device in Example 4.
Fig. 7 is a diagram showing current-voltage characteristics of a switching device in Example 5.
Fig. 8 is a diagram showing current-voltage characteristics of a switching device in Example 7.
Fig. 9 is a diagram showing current-voltage characteristics of a switching device in Example 8.
Fig. 10 is a diagram showing current-voltage characteristics of a switching device in Example 9.
Fig. 11 is a diagram showing a concept of current-voltage characteristics of a conventional switching device.
Fig. 12 is a conceptual diagram showing a structure of a conventional two-component organic bistable material.

### Best Mode for Carrying Out the Invention

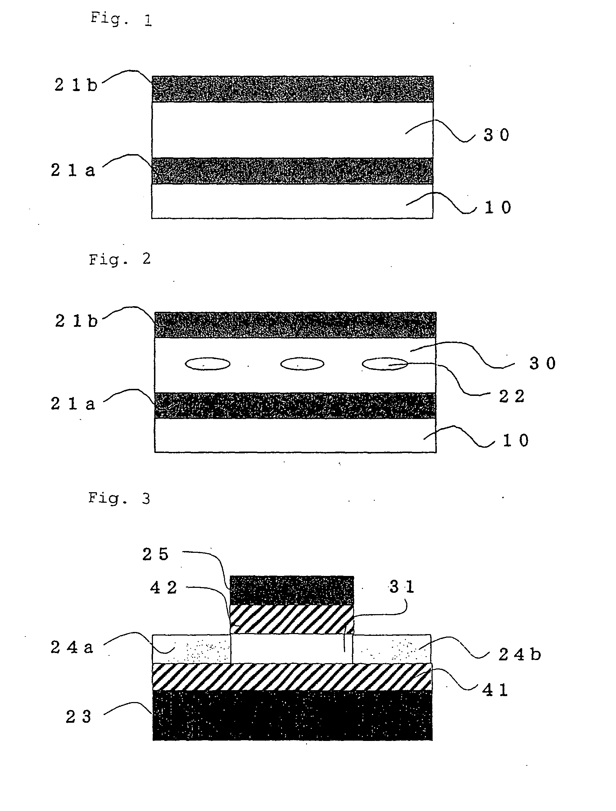

The invention will be described in detail with reference to the drawings. Fig. 1 is a schematic constitutional view showing one embodiment of the switching device of the invention.

As shown in Fig. 1, the switching device has a substrate 10 having accumulated sequentially thereon a first electrode layer 21a, an organic bistable material layer 30 and a second electrode layer 21b.

The substrate 10 is not particularly limited and is preferably a glass substrate or the like, which has been known in the art.

The first electrode layer 21a and the second electrode layer 21b may be appropriately selected from a metallic material, such as aluminum, gold, silver, chromium, nickel and iron, an inorganic material, such as ITO and carbon, an organic material, such as a conjugated organic material and a liquid crystal, and a semiconductor material, such as silicon without particular limitation, and are preferably aluminum from the standpoint of adhesiveness and chemical stability.

The thin film forming method for the first electrode layer 21a and the second electrode layer 21b may be, for example, a vacuum vapor deposition method and a sputtering method, which have been known in the art. It is possible in the film forming methods that a method of introducing reactive gases such as oxygen, water, nitrogen or the like into a vacuum atmosphere is carried out, or an electric field or discharge is effected in a vacuum atmosphere, in addition to the ordinary vacuum atmosphere, whereby the properties of the film forming material can be controlled. In the sputtering method, a direct current method and an RF method, which have been ordinarily employed, may be used, but the invention is not limited thereto.

In the case where the first electrode layer 21a and the second electrode layer 21b are formed by vacuum vapor deposition, the substrate temperature upon vapor deposition is preferably from 0 to 150°C while it is appropriately selected depending on the material used as the electrodes. The thickness thereof is preferably from 50 to 200 nm.

The organic bistable material layer 30 is formed on the first electrode layer 21a. The organic bistable material used in the organic bistable material layer 30 has a functional group for transporting charge.

In the invention, the triphenylamine compound represented by the following general formulae (I) to (III) is used as the organic bistable material: 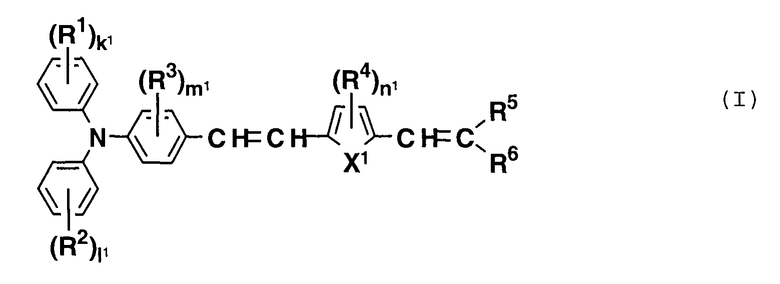 wherein R¹ to R⁴ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, and a residual group forming a ring, which may have a substituent, provided that R¹ to R⁴ may be the same as or different from each other; R⁵ and R⁶ each represents one selected from an alkyl group having from 1 to 6 carbon atoms, which may have a substituent, an aryl group, which may have a substituent, a heterocyclic group, which may have a substituent, and a residual group forming a ring, which may have a substituent, provided that R⁵ and R⁶ may be the same as or different from each other; X¹ represents an oxygen atom or a sulfur atom; k¹ and l¹ each represents an integer of from 1 to 5; m¹ represents an integer of from 1 to 4; and n¹ represents an integer of 1 or 2, 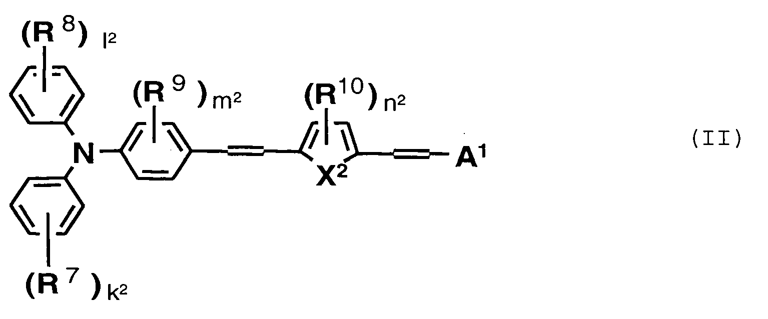 wherein R⁷ to R¹⁰ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, and a residual group forming a ring, which may have a substituent, provided that R⁷ to R¹⁰ may be the same as or different from each other; A¹ represents an aromatic condensed polycyclic group, which may have a substituent; X² represents an oxygen atom or a sulfur atom; k² and l² each represents an integer of from 1 to 5; m² represents an integer of from 1 to 4; and n² represents an integer of 1 or 2, and 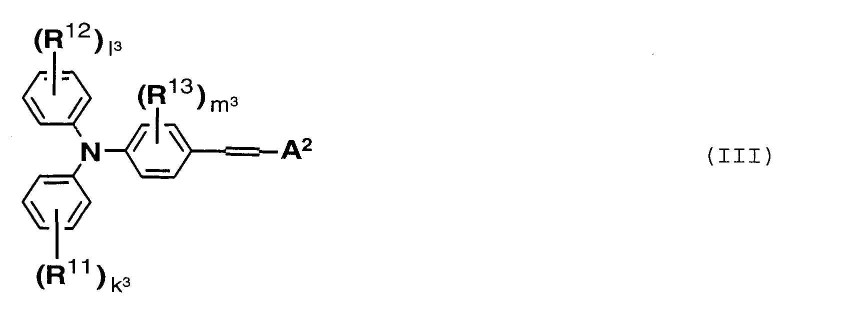 wherein R¹¹ to R¹³ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, and a residual group forming a ring, which may have a substituent, provided that R¹¹ to R¹³ may be the same as or different from each other; A² represents an aromatic condensed polycyclic group, which may have a substituent; k³ and l³ each represents an integer of from 1 to 5; and m3 represents an integer of from 1 to 4.

Specific examples of the compound represented by the formula (I) include compounds represented by the following structural formulae (I-1) to (I-19):

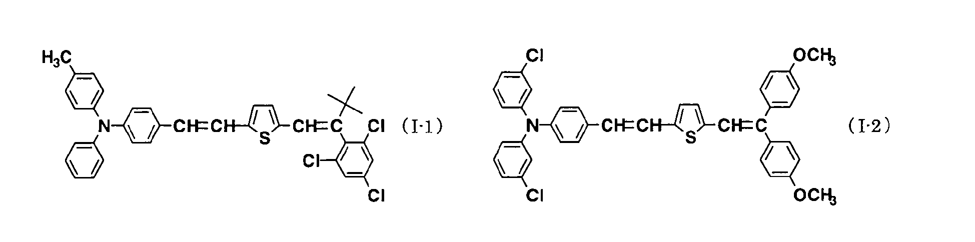

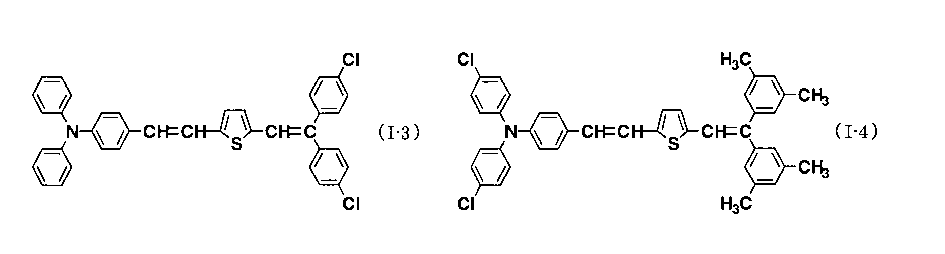

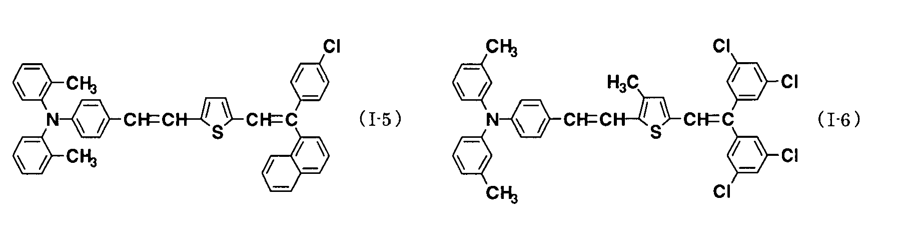

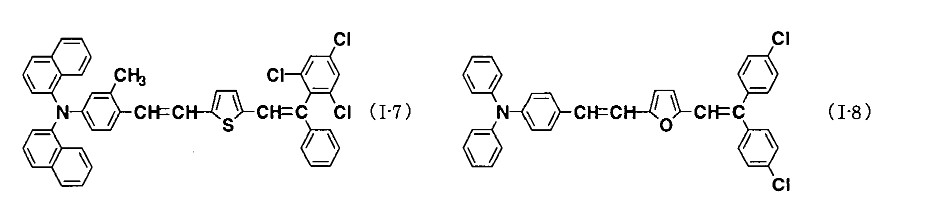

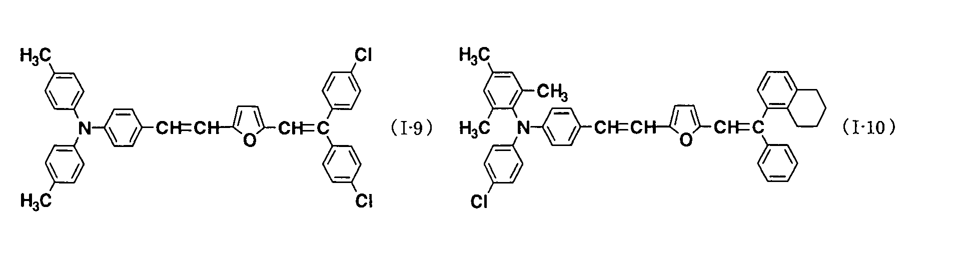

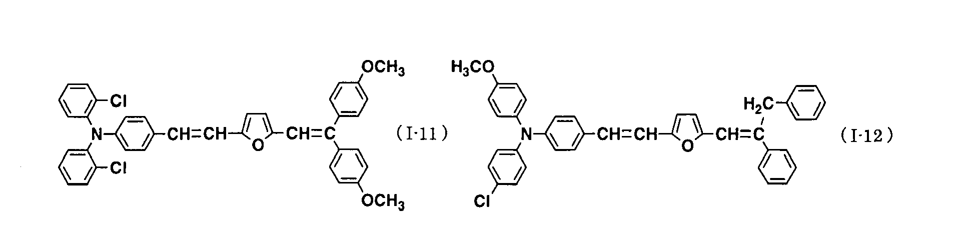

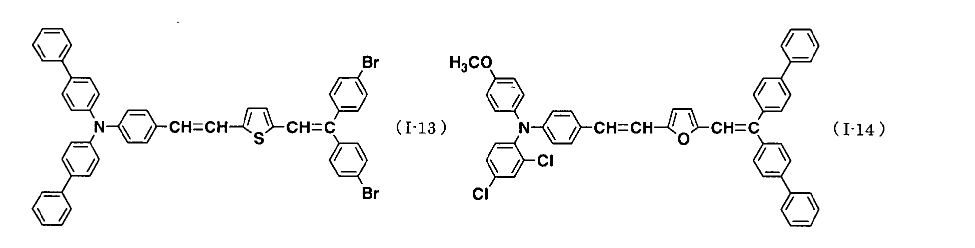

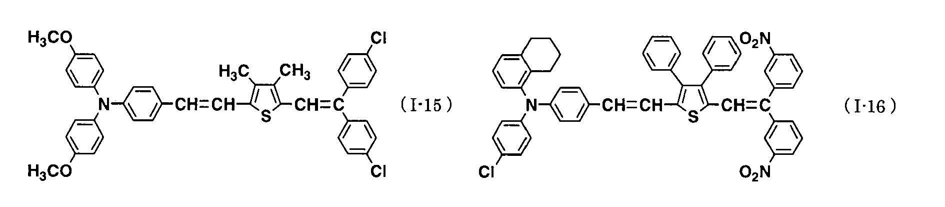

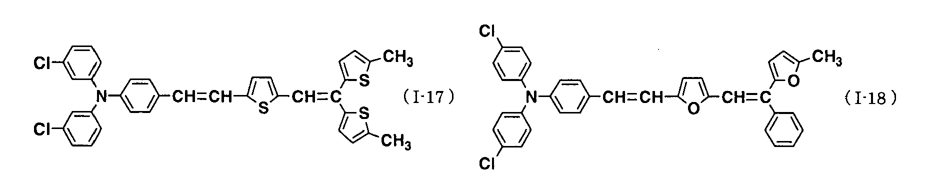

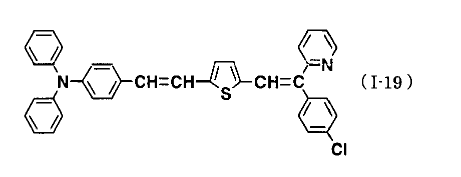

The triphenylamine compound represented by the general formula (I), for example, the compound represented by the structural formula (I-3) can be synthesized by the following reaction scheme. Accordingly, as shown in the following reaction scheme, the compound can be synthesized by reacting a compound represented by the structural formula (I-A) and a compound represented by the structural formula (I-B) under a basic condition (for example, n-BuLi) in a suitable organic solvent (for example, dimethylformamide). The compounds represented by the general formula (I) having other structures can also be synthesized in the similar method.

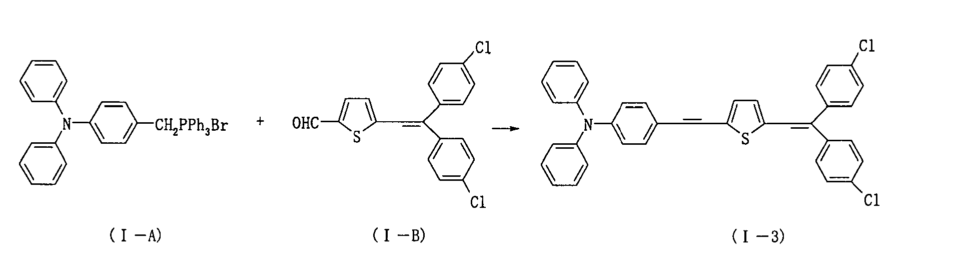

Specific examples of the compound represented by the formula (II) include compounds represented by the following structural formulae (II-1) to (II-18):

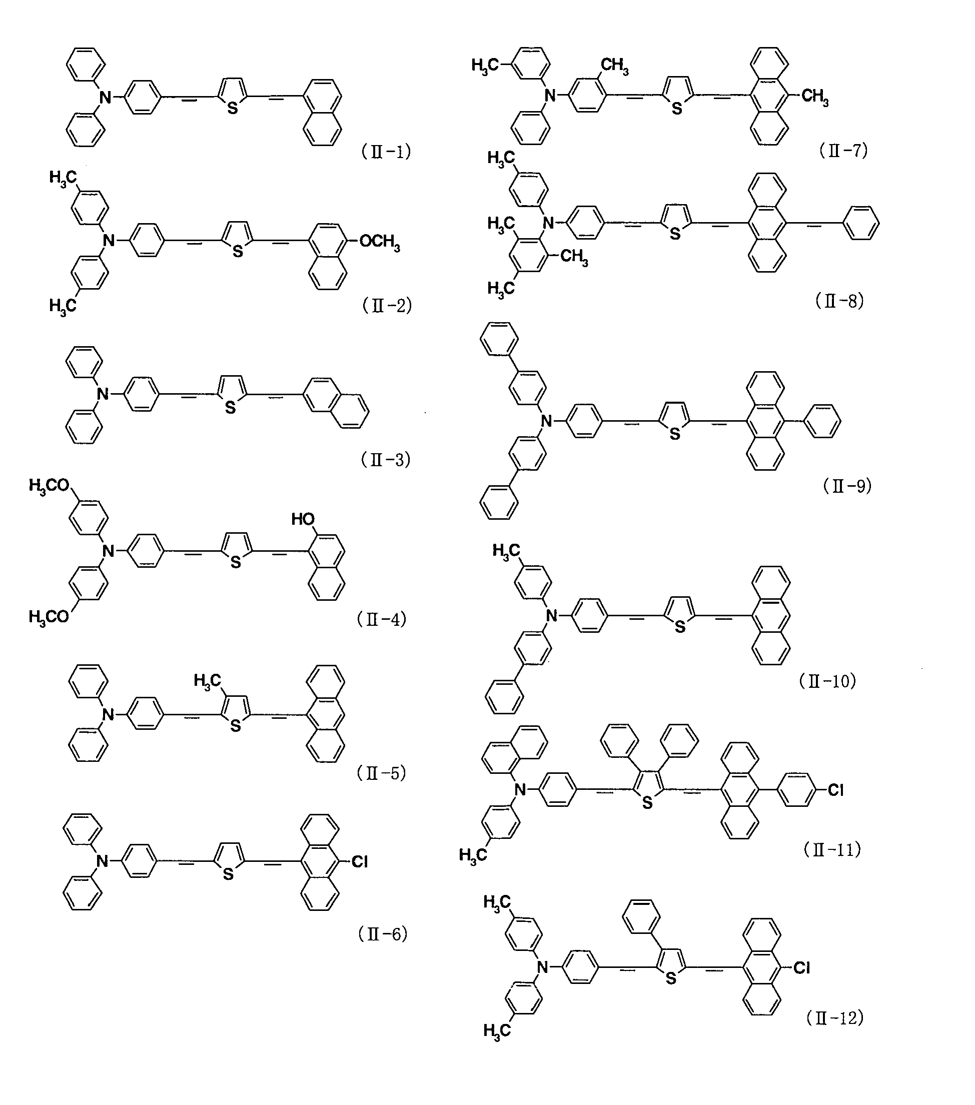

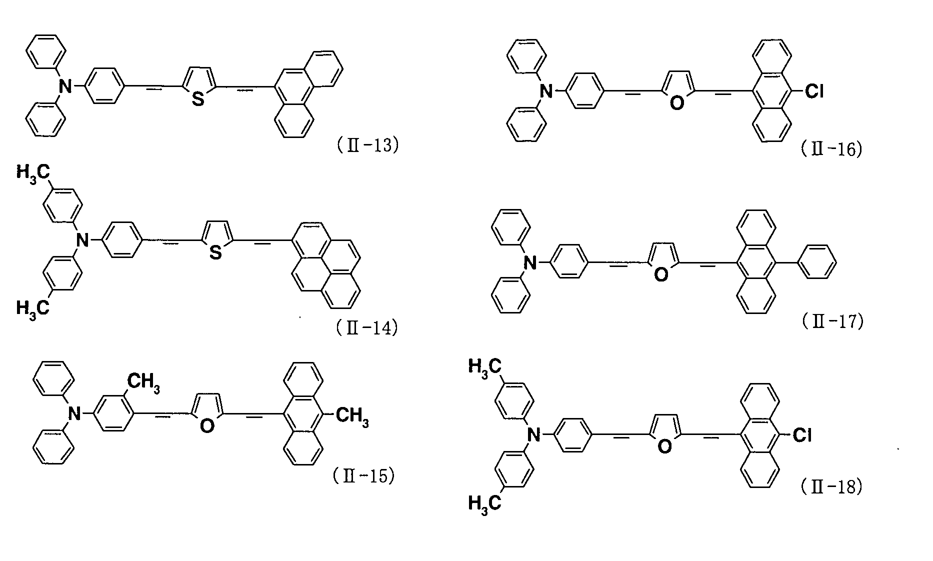

The triphenylamine compound represented by the general formula (II), for example, the compound represented by the structural formula (II-6) can be synthesized by the following reaction scheme. Accordingly, as shown in the above reaction scheme, the compound can be synthesized by reacting a compound represented by the structural formula (II-A) and a compound represented by the structural formula (II-B) under a basic condition (for example, n-BuLi) in a suitable organic solvent (for example, dimethylformamide). The compounds represented by the general formula (II) having other structures can also be synthesized in the similar method.

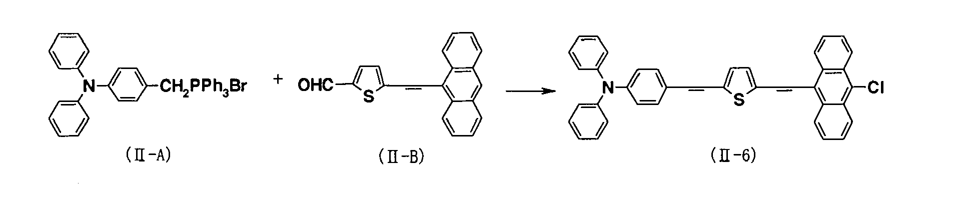

Specific examples of the compound represented by the formula (III) include compounds represented by the following structural formulae (III-1) to (III-12):

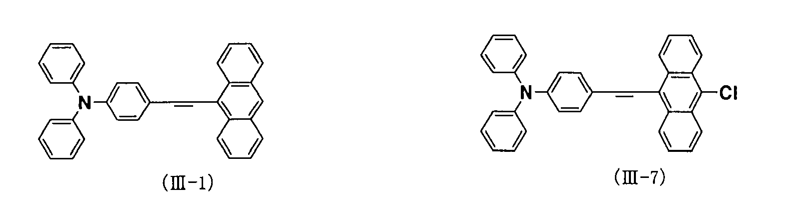

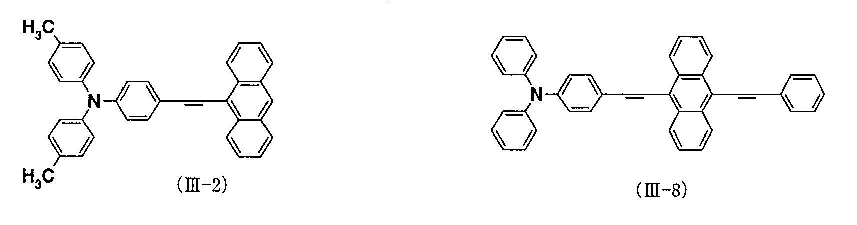

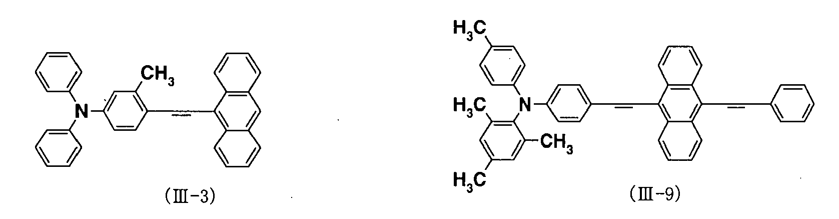

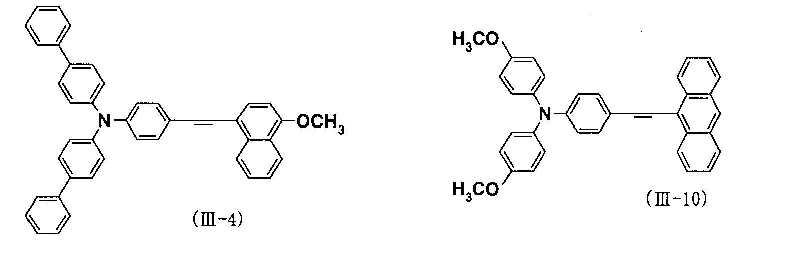

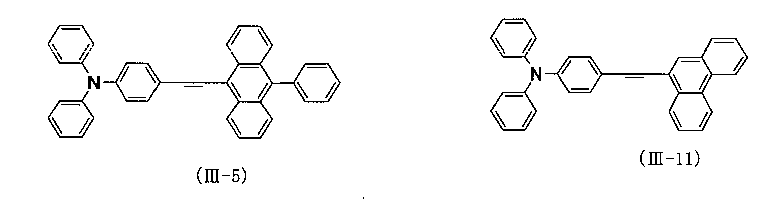

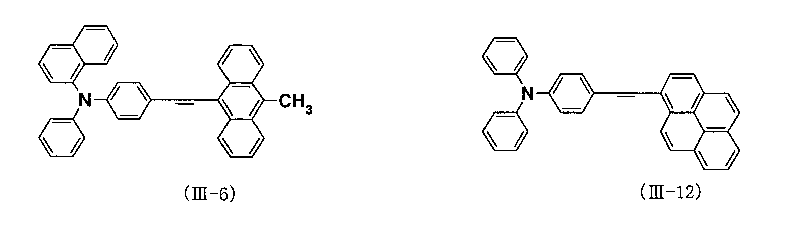

The triphenylamine compound represented by the general formula (III), for example, the compound represented by the structural formula (111-2) can be synthesized by the following reaction scheme. Accordingly, as shown in the above reaction scheme, the compound can be synthesized by reacting a compound represented by the structural formula (III-A) and a compound represented by the structural formula (III-B) under a basic condition (for example, n-BuLi) in a suitable organic solvent (for example, dimethylformamide). The compounds represented by the general formula (III) having other structures can also be synthesized in the similar method.

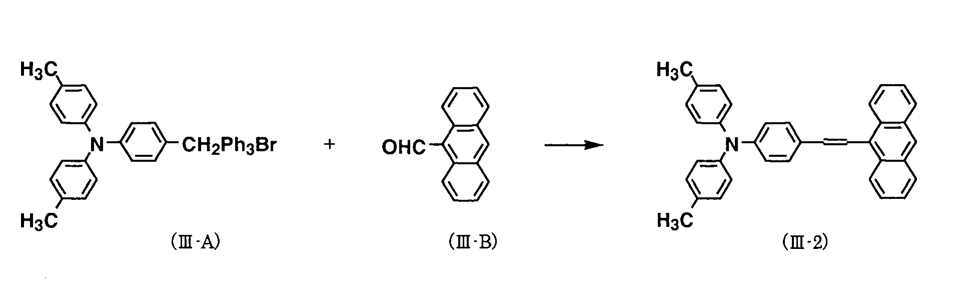

Examples of a method for forming the organic bistable material layer 30 include a vacuum vapor deposition method, a spin coating method, an electrolytic polymerization method, a chemical vapor depositionmethod (CVD method), amonomolecular film accumulation method (LB method), a dipping method, a bar coating method, an ink-jet method and a screen printing method, but the invention is not limited thereto.

In the case where the organic bistable material layer 30 is formed by vacuum vapor deposition, the substrate temperature upon vapor deposition is preferably from 0 to 100°C while it is appropriately selected depending on the organic bistable material to be used. The thickness thereof is preferably from 20 to 150 nm.

In the case where the organic bistable material layer 30 is formed by coating, for example, by a spin coating method, examples of the coating solvent include a halogen solvent, such as dichloromethane, dichloroethane and chloroform, an ether solvent, such as tetrahydrofuran (THF) and ethylene glycol dimethyl ether, an aromatic solvent, such as toluene and xylene, an alcohol solvent, such as ethyl alcohol, an ester solvent, such as ethyl acetate and butyl acetate, a ketone solvent, such as acetone and MEK, and acetonitrile. The organic bistable material is dissolved in the solvent in an amount of from 0. 001 to 30% by mass, to which a binder resin is added depending on necessity, to form a coating composition. Examples of the binder resin include polycarbonate, polyester, polyvinyl alcohol and polystyrene. The condition upon spin coating may be appropriately determined depending on the target thickness, and is preferably a rotation number of from 200 to 3,600 rpm.

The constitution of the switching device of the invention is not limited to the constitution shown in Fig. 1, but the constitutions shown in Figs. 2 and 3 may also be used.

The embodiment shown in Fig. 2 is different from the embodiment shown in Fig. 1 in such a point that a third electrode 22 is provided within the organic bistable material layer 30 to constitute a three-terminal device. According to the constitution, the bias Vb shown in Fig. 11 is applied to the electrode layers 21a and 21b as electrodes, to which an addition current is applied, and the low threshold voltage Vth1 or the high threshold voltage Vth2 shown in Fig. 11 is applied to the third electrode 22 as an electrode for controlling the resistance state of the bistable material layer 30.

In the embodiment shown in Fig. 3, an insulating layer 41 is formed on a second electrode layer 23, an organic bistable material layer 31 and electrode layers 24a and 24b sandwiching the organic bistable material layer 31 from both sides thereof are formed on the insulating layer 41, and an insulating layer 42 and a fourth electrode layer 25 are formed sequentially on the bistable material layer 31, to constitute a four-terminal device.

In the switching device, for example, the third electrode 23 may be a silicon substrate, the insulating layers 41 and 42 may be metallic oxide vapor deposition films, and the electrode layers 24a and 24b and the fourth electrode 25 may be aluminum vapor deposition films. The bias Vb shown in Fig. 11 is applied to the electrode layers 24a and 24b as electrodes, to which an addition current is applied, and an electric field is applied to the organic bistable material layer 31 with the third electrode 23 and the fourth electrode 25 to control the resistance state of the organic bistable material layer 31.

As having described hereinabove, according to the invention, such a switching device can be provided that is suppressed in fluctuation in material composition, is capable of providing uniform bistable characteristics, is suitable for mass-production, and is excellent in repetition performance. Accordingly, the switching device is favorably applied to a switching device for driving an organic EL display panel, and a high density memory.

The switching device of the invention will be described in more detail with reference to examples.

### Production of Switching Devices using Compounds of General Formula (I) (Examples 1 to 3)

### Example 1

A switching device having the constitution shown in Fig. 1 was produced in the following manner.

On a glass substrate used as a substrate 10, aluminum as an electrode layer 21a, a triphenylamine compound as an organic bistable material layer 30, and aluminum as an electrode layer 21b were formed as thin films sequentially and continuously by vacuum vapor deposition method, so as to produce a switching device of Example 1. The compound of the structural formula (I-3) was used as the triphenylamine compound.

The electrode layer 21a, the organic bistable material layer 30 and the electrode layer 21b were formed to have thickness of 100 nm, 80 nm and 100 nm, respectively. The vapor deposition apparatus was operated at a vacuum degree of 3 × 10⁻⁶ torr by evacuation with a diffusion pump. Vapor deposition of aluminum was carried out by a resistance heating method at a film forming rate of 3 Å/sec, and vapor deposition of the triphenylamine compound was carried out by a resistance heating method at a film forming rate of 2 Å/sec. Vapor deposition of the layers was carried continuously in the same vapor deposition apparatus under such conditions that the specimen was not in contact with the air during vapor deposition.

### Example 2

A switching device was produced in the same manner as in Example 1 except that the organic bistable material represented by the structural formula (I-3) used in Example 1 was replaced by the organic bistable material represented by the structural formula (I-8).

### Example 3

A switching device was produced in the same manner as in Example 1 except that the organic bistable material represented by the structural formula (I-3) used in Example 1 was replaced by the organic bistable material represented by the structural formula (I-9).

### Test Example 1

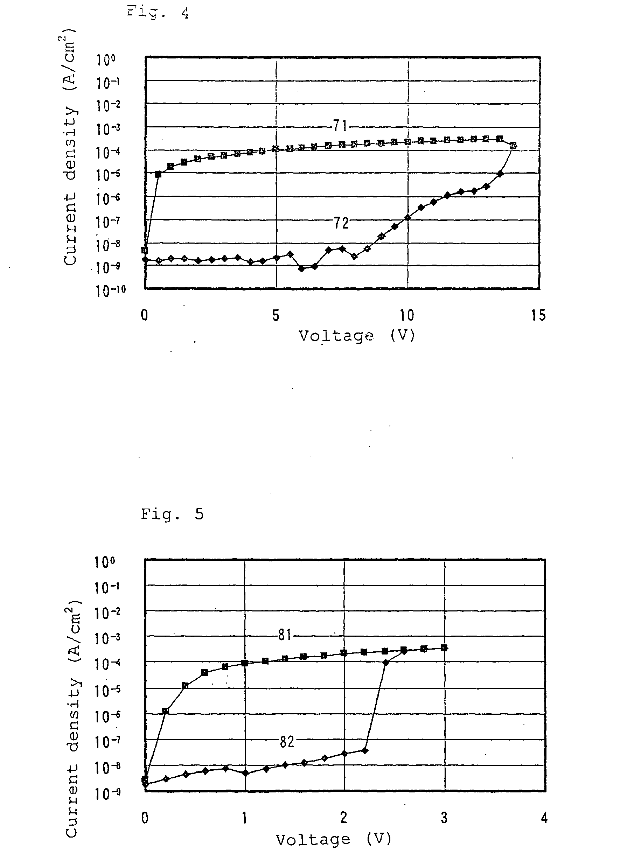

The switching devices of Examples 1 to 3 were measured for current-voltage characteristics in a room temperature environment, and the low threshold voltage Vth1 and the high threshold voltage Vth2 as the threshold voltages in Fig. 11 were measured. The results are summarized in Table 1. Figs. 4 and 5 show the current-voltage characteristics of the switching devices Examples 1 and 2, respectively.

As the measuring conditions, an electric resistance in a range of from 100 Ω to 1 MΩ was connected in series to the devices, whereby the electric current in the on state was restricted to suppress the devices from being damaged.

**Table 1**

| | Vth1 (V) | Vth2 (V) |
|---|---|---|
| Example 1 | 0 | 14.0 |
| Example 2 | 0 | 2.6 |
| Example 3 | 0.5 | 4.7 |

As understood from the results shown in Figs. 4 and 5, the switching devices of Examples 1 to 4 provided bistability including the high resistance state 71 or 81 and the low resistance state 72 or 82.

In Example 1 shown in Fig. 4, at a low threshold voltage Vth1 of 0 V or less, the device transited from the low resistance state 72 to the high resistance state 71 (from the on state to the off state) to change the resistance value. At a high threshold voltage Vth2 of 14.0 V or more, the device transited from the high resistance state 71 to the low resistance state 72 (from the off state to the on state) to change the resistance value, at which about 1 × 10⁵ was obtained as a ratio of the low resistance state and the high resistance state.

In Example 2 shown in Fig. 5, at a low threshold voltage Vth1 of 0 V or less, the device transited from the low resistance state 82 to the high resistance state 81 (from the on state to the off state) to change the resistance value. At a high threshold voltage Vth2 of 2.6 V or more, the device transited from the high resistance state 81 to the low resistance state 82 (from the off state to the on state) to change the resistance value, at which about 1 × 10⁴ was obtained as a ratio of the low resistance state and the high resistance state.

Bistability was obtained in all the switching devices of Examples 1 to 3, and bistable states with a low threshold voltage Vth1 of from 0 to 0.5 V and a high threshold voltage Vth2 of from 2.6 to 14.0 V as shown in Table 1 were obtained. Production of Switching Devices using Compounds of General Formula (II) (Examples 4 to 6)

### Example 4

A switching device having the constitution shown in Fig. 1 was produced in the following manner.

On a glass substrate used as a substrate 10, aluminum as an electrode layer 21a, a triphenylamine compound as an organic bistable material layer 30, and aluminum as an electrode layer 21bwere formed as thin films sequentially and continuously by vacuum vapor deposition method, so as to produce a switching device of Example 4. The compound of the structural formula (II-6) was used as the triphenylamine compound.

The electrode layer 21a, the organic bistable material layer 30 and the electrode layer 21b were formed to have thickness of 100 nm, 80 nm and 100 nm, respectively. The vapor deposition apparatus was operated at a vacuum degree of 3 × 10⁻⁶ torr by evacuation with a diffusion pump. Vapor deposition of aluminum was carried out by a resistance heating method at a film forming rate of 3 Å/sec, and vapor deposition of the triphenylamine compound was carried out by a resistance heating method at a film forming rate of 2 Å/sec. Vapor deposition of the layers was carried continuously in the same vapor deposition apparatus under such conditions that the specimen was not in contact with the air during vapor deposition.

### Example 5

A switching device was produced in the same manner as in Example 4 except that the organic bistable material represented by the structural formula (II-6) used in Example 4 was replaced by the organic bistable material represented by the structural formula (II-9).

### Example 6

A switching device was produced in the same manner as in Example 4 except that the organic bistable material represented by the structural formula (II-6) used in Example 4 was replaced by the organic bistable material represented by the structural formula (II-10).

### Test Example 2

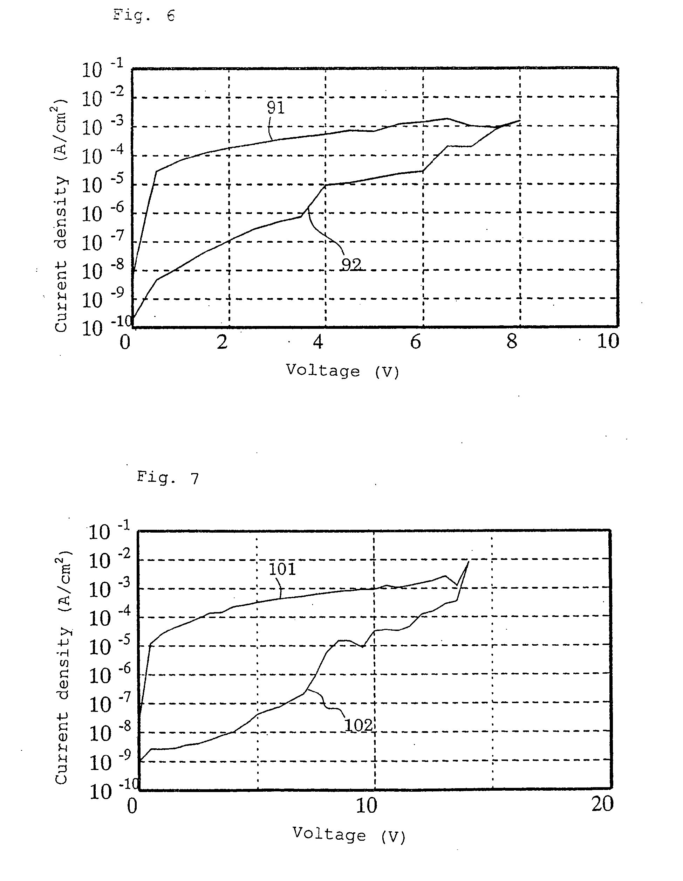

The switching devices of Examples 4 to 6 were measured for current-voltage characteristics in a room temperature environment, and the low threshold voltage Vth1 and the high threshold voltage Vth2 as the threshold voltages in Fig. 11 were measured. The results are summarized in Table 2. Figs. 6 and 7 show the current-voltage characteristics of the switching devices Examples 4 and 5, respectively.

As the measuring conditions, an electric resistance in a range of from 100 Ω to 1 MΩ was connected in series to the devices, whereby the electric current in the on state was restricted to suppress the devices from being damaged.

**Table 2**

| | Vth1 (V) | Vth2 (V) |
|---|---|---|
| Example 4 | 0 | 7.5 |
| Example 5 | 0 | 13.5 |
| Example 6 | 0.5 | 4.3 |

As understood from the results shown in Figs. 6 and 7, the switching devices of Examples 4 and 5 provided bistability including the high resistance state 91 or 101 and the low resistance state 92 or 102.

In Example 4 shown in Fig. 6, at a low threshold voltage Vth1 of 2 V or less, the device transited from the low resistance state 92 to the high resistance state 91 (from the on state to the off state) to change the resistance value. At a high threshold voltage Vth2 of 7.5 V or more, the device transited from the high resistance state 91 to the low resistance state 92 (from the off state to the on state) to change the resistance value, at which about 2 × 10³ with 2 V was obtained as a ratio of the low resistance state and the high resistance state.

In Example 5 shown in Fig. 7, at a low threshold voltage Vth1 of 0 V or less, the device transited from the low resistance state 102 to the high resistance state 101 (from the on state to the off state) to change the resistance value. At a high threshold voltage Vth2 of 13.5 V or more, the device transited from the high resistance state 101 to the low resistance state 102 (from the off state to the on state) to change the resistance value, at which about 1 × 10⁴ with 5 V was obtained as a ratio of the low resistance state and the high resistance state.

Bistability was obtained in all the switching devices of Examples 4 to 6, and bistable states as shown in Table 2 were obtained.

### Production of Switching Devices using Compounds of General Formula (III) (Examples 7 to 9)

### Example 7

A switching device having the constitution shown in Fig. 1 was produced in the following manner.

On a glass substrate used as a substrate 10, aluminum as an electrode layer 21a, a triphenylamine compound as an organic bis table material layer 30, and aluminum as an electrode layer 21b were formed as thin films sequentially and continuously by vacuum vapor deposition method, so as to produce a switching device of Example 7. The compound of the structural formula (III-1) was used as the triphenylamine compound.

The electrode layer 21a, the organic bistable material layer 30 and the electrode layer 21b were formed to have thickness of 100 nm, 80 nm and 100 nm, respectively. The vapor deposition apparatus was operated at a vacuum degree of 3 × 10⁻⁶ torr by evacuation with a diffusion pump. Vapor deposition of aluminum was carried out by a resistance heating method at a film forming rate of 3 Å/sec, and vapor deposition of the triphenylamine compound was carried out by a resistance heating method at a film forming rate of 2 Å/sec. Vapor deposition of the layers was carried continuously in the same vapor deposition apparatus under such conditions that the specimen was not in contact with the air during vapor deposition.

### Example 8

A switching device was produced in the same manner as in Example 7 except that the organic bistable material represented by the structural formula (III-1) used in Example 7 was replaced by the organic bistable material represented by the structural formula (III-7).

### Example 9

A switching device was produced in the same manner as in Example 7 except that the organic bistable material represented by the structural formula (III-1) used in Example 7 was replaced by the organic bistable material represented by the structural formula (III-9).

### Test Example 3

The switching devices of Examples 7 to 9 were measured for current-voltage characteristics in a room temperature environment, and the low threshold voltage Vth1 and the high threshold voltage Vth2 as the threshold voltages in Fig. 11 were measured. The results are summarized in Table 3. Figs. 8 to 10 show the current-voltage characteristics of the switching devices Examples 7 to 9, respectively.

**Table 3**

| | Vth1 (V) | Vth2 (V) |
|---|---|---|
| Example 7 | 0.0 | 3.2 |
| Example 8 | 1.0 | 15.5 |
| Example 9 | 0.0 | 5.0 |

As understood from the results shown in Figs. 8 to 10, the switching devices of Examples 7 to 9 provided bistability including the high resistance state 111, 121 or 131 and the low resistance state 112, 122 or 132.

In Example 7 shown in Fig. 8, at a low threshold voltage Vth1 of 0.0 V, the device transited from the low resistance state 112 to the high resistance state 111 (from the on state to the off state) to change the resistance value. At a high threshold voltage Vth2 of 3.2 V or more, the device transited from the high resistance state 111 to the low resistance state 112 (from the off state to the on state) to change the resistance value, at which about 10³ was obtained as a ratio of the low resistance state and the high resistance state.

In Example 8 shown in Fig. 9, at a low threshold voltage Vth1 of 0.0 V, the device transited from the low resistance state 122 to the high resistance state 121 (from the on state to the off state) to change the resistance value. At a high threshold voltage Vth2 of 15.5 V or more, the device transited from the high resistance state 121 to the low resistance state 122 (from the off state to the on state) to change the resistance value, at which about 10² was obtained as a ratio of the low resistance state and the high resistance state.

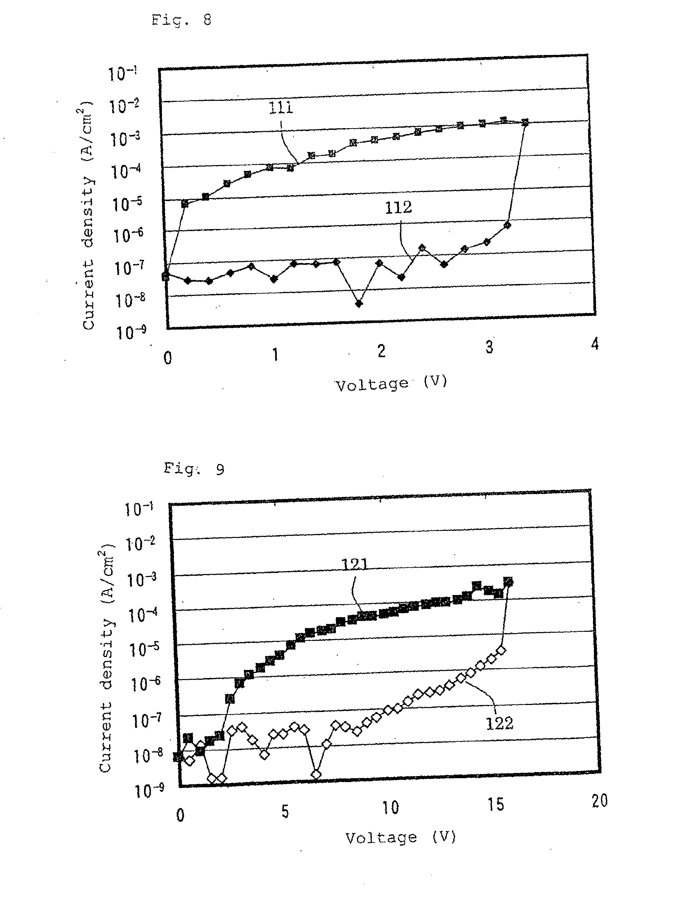

In Example 9 shown in Fig. 10, at a low threshold voltage Vth1 of 0.0 V, the device transited from the low resistance state 132 to the high resistance state 131 (from the on state to the off state) to change the resistance value. At a high threshold voltage Vth2 of 5.0 V or more, the device transited from the high resistance state 131 to the low resistance state 132 (from the off state to the on state) to change the resistance value, at which about 10² was obtained as a ratio of the low resistance state and the high resistance state.

Accordingly, bistability was obtained in all the switching devices of Examples 7 to 9, and bistable states with a low threshold voltage Vth1 of from 0.0 to 1.0 V and a high threshold voltage Vth2 of from 3.2 to 15.5 V as shown in Table 4 were obtained.

### Industrial Applicability

The switching device of the invention is suppressed in fluctuation in material composition, is capable of providing uniform bistable characteristics, is suitable for mass-production, and is excellent in repetition performance, and therefore, the switching device is favorably applied to a switching device for driving an organic EL display panel, and a high density memory.

## Claims

1. A switching device comprising a thin film comprising an organic material disposed between at least two electrodes, **characterized in that** the organic material is a triphenylamine compound represented by the following general formula (I): 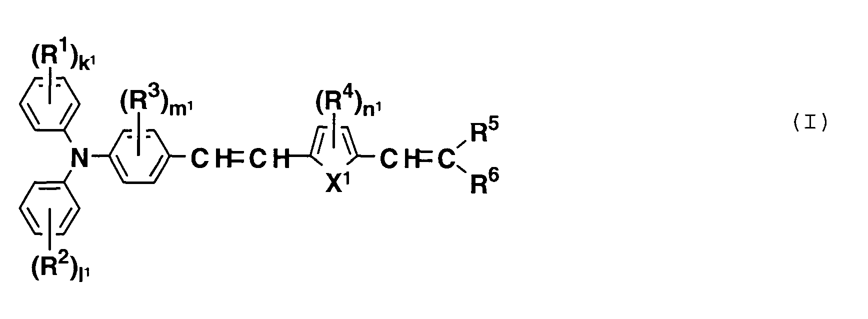 wherein R¹ to R⁴ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, and a residual group forming a ring, which may have a substituent, provided that R¹ to R⁴ may be the same as or different from each other; R⁵ and R⁶ each represents one selected from an alkyl group having from 1 to 6 carbon atoms, which may have a substituent, an aryl group, which may have a substituent, a heterocyclic group, which may have a substituent, and a residual group forming a ring, which may have a substituent, provided that R⁵ and R⁶ may be the same as or different from each other; X¹ represents an oxygen atom or a sulfur atom; k¹ and l¹ each represents an integer of from 1 to 5; m¹ represents an integer of from 1 to 4; and n¹ represents an integer of 1 or 2.

2. A switching device comprising a thin film comprising an organic material disposed between at least two electrodes, **characterized in that** the organic material is a triphenylamine compound represented by the following general formula (II): 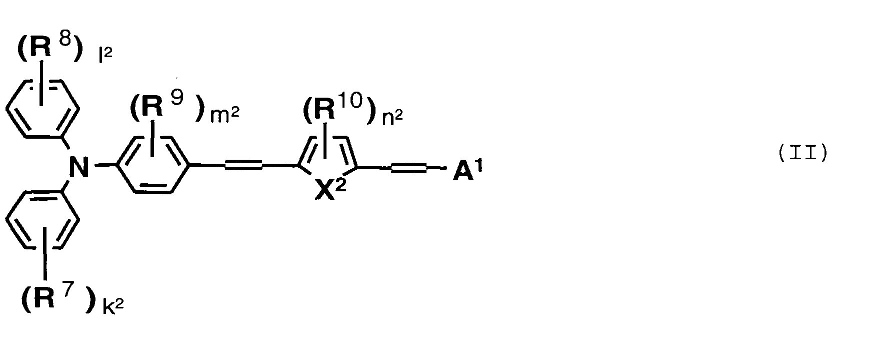 wherein R⁷ to R¹⁰ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, anda residual group forming a ring, which may have a substituent, provided that R⁷ to R¹⁰ may be the same as or different from each other; A¹ represents an aromatic condensed polycyclic group, which may have a substituent; X² represents an oxygen atom or a sulfur atom; k² and l² each represents an integer of from 1 to 5; m² represents an integer of from 1 to 4; and n² represents an integer of 1 or 2.

3. A switching device comprising a thin film comprising an organic material disposed between at least two electrodes, **characterized in that** the organic material is a triphenylamine compound represented by the following general formula (III): 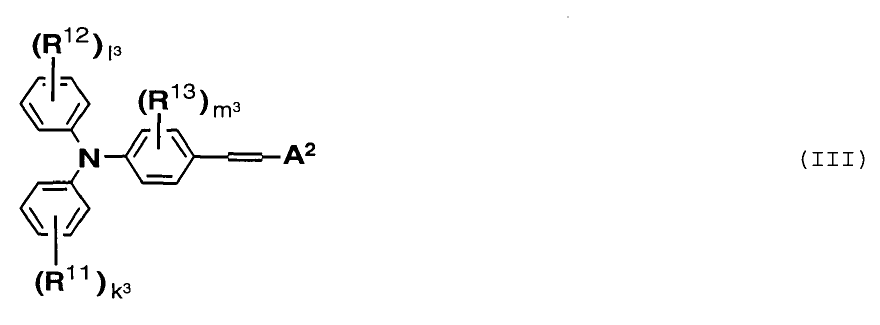 wherein R¹¹ to R¹³ each represents one selected from a hydrogen atom, a halogen atom, an alkyl group having from 1 to 6 carbon atoms, which may have a substituent, an alkoxyl group having from 1 to 6 carbon atoms, which may have a substituent, an aryl group, which may have a substituent, anda residual group forming a ring, which may have a substituent, provided that R¹¹ to R¹³ may be the same as or different from each other; A² represents an aromatic condensed polycyclic group, which may have a substituent; k³ and l³ each represents an integer of from 1 to 5; and m³ represents an integer of from 1 to 4.
